Europäisches Patentamt

European Patent Office

Office européen des brevets

(19)

Publication number: **0 300 600**

**A2**

(12) **EUROPEAN PATENT APPLICATION**

(21) Application number: 88304810.0

(22) Date of filing: 27.05.88

(51) Int. Cl.⁴ **H05K 7/10 , H01R 23/68**

(30) Priority: 24.07.87 GB 8717613

(43) Date of publication of application:
**25.01.89 Bulletin 89/04**

(84) Designated Contracting States:
**AT BE CH DE ES FR GR IT LI LU NL SE**

(71) Applicant: **PLESSEY OVERSEAS LIMITED**
**Vicarage Lane**
**Ilford Essex IGl 4AQ(GB)**

(72) Inventor: **Curtis, Vincent**
**20 Greenway**
**Greasby Wirral(GB)**

(74) Representative: **Allen, Derek et al**
**The Plessey Company plc Intellectual**
**Property Department Vicarage Lane**
**Ilford Essex, IG1 4AQ(GB)**

(54) **A method of connection and a module for use therein.**

(57) A method of Hierarchical Interconnection Technology (HIT) connection using improved child and daughter boards. The improved child and daughter boards have chamferred edges thereby enabling a press-fit means of connection. This means of connection improves reliability and the MTBF since there is no need to provide separable connectors, which previously contributed to problems of heat dissipation and self-inductance.

*FIG. 4.*

EP 0 300 600 A2

# A METHOD OF CONNECTION AND A MODULE FOR USE THEREIN.

The present invention relates to a method of Hierarchical Interconnection Technology (HIT) connection and a module for use in the said method.

Hierarchical Interconnection Technology (HIT) has been designed to cater for the increase in component device connections due to the increase in component density of a module as a result of using surface mounted devices.

This technology involves the partitioning of large-area boards into small high-density modules. Hitherto, these modules, called child boards, have been parallel mounted onto a larger, daughter board using separable connectors. These connectors provide contacts on all four edges of the childs boards. The contacts of the connectors may be reflow soldered onto pads on the child board. The connector and child board becoming an integral assembly. This assembly is then connected to the daughter board using a clamping frame. Alternatively the connector may be soldered permanently onto the daughter board, either with through-hole or surface mount terminations. The child board can then be clamped onto the connector. In either case, the clamping frame provides the force required to mate the daughter, connector and child board.

Unfortunately, the introduction of the connector reduces the mean time before failure (MTBF).

Furthermore, this method of connection is prone to self-inductance considerations at higher frequencies and poor thermal dissipation characteristics.

It is an aim, therefore, of the present invention to provide a method of HIT connection and a module for use in said method for substantially alleviating the aforementioned difficulties.

According to the present invention, there is provided a method of connection for a Hierarchical Interconnection Technology (HIT) system, comprising a module and a board having at least one aperture for receiving the module, superimposing the module on the aperture, applying a force to the module and the board substantially normal to the plane of the board, and removing the force when at least part of the edges of the module and the walls of the aperture are contacting.

The present invention further provides a module for use in a HIT system comprising two planes having edges therebetween, whereby at least one of the edges is chamfered.

The present invention further provides a board for use in a HIT system, comprising at least one aperture having walls, whereby at least one of the walls is chamferred.

According to the present invention, there is also provided a HIT system comprising a board having at least one aperture, at least one module having edges, and the aperture having walls for contacting with the edges of the module.

The present invention will now further be described with reference to the accompanying drawings, of which:

Figure 1 is a schematic diagram of a HIT system with a means of connection according to the prior art;

Figure 2 is a schematic diagram of a child board connected to a daughter board in accordance with the prior art.

Figure 3 is a schematic diagram of a daughter board and a child board unconnected but in accordance with the present invention: and

Figure 4 is a cross-section through the plane AA of the child board coupled to the daughter board both as shown in Figure 3.

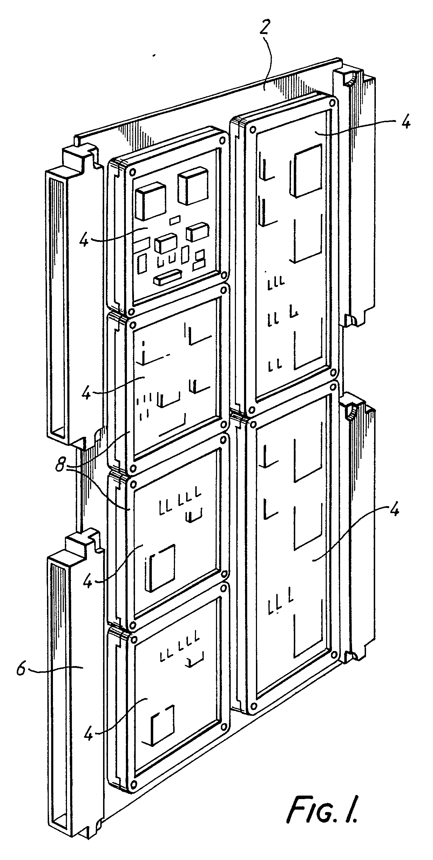

Figure 1 illustrates a typical HIT system comprising a daughter board 2 and six child boards 4. This assembly incorporates known back plane connectors 6 for coupling to a mother board (not shown). The child boards 4 are connected to the daughter board 2 by a known connector system consisting of clamping frames 8.

This connector system is further illustrated in Figure 2. The contact elements 9 provide an electrical connection for the child board 4 and the daughter board 2. Whilst the connector body 10 and clamping frame 8 provide support and a mechanical connection. The introduction of this connecting system 8, 9, 10 reduces the reliability of the connection and reduces the MTBF. Furthermore, a heatsink plane 11 must be employed to increase heat dissipation since this method of connection reduces the air flow over the boards 2, 4.

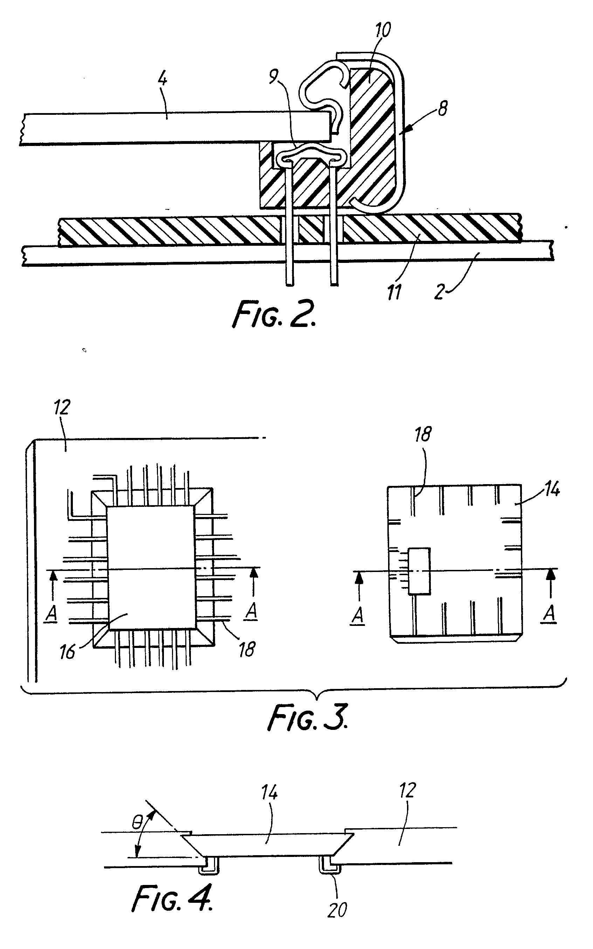

In accordance with the present invention, there is shown in Figure 3 a daughter board 12 and a child board 14. The daughter board 12 is provided with an aperture 16 for receiving the child board 14. The walls of the aperture 16 and the edges of the child board 14 are chamferred at an angle $\phi$ with respect to the plane of the boards 12, 14. Where by the plane of the boards is taken to be the plane in which the boards lie parallel to the major surfaces of the boards. The method of connection for these boards 12, 14 as follows:

The child board 14 is superimposed upon the aperture 16; a force is applied to the child board 14 and daughter board 12 in a direction perpendicular to the plane of the boards: and the force is removed when each edge of the child board 14 mates with a respective wall of the aperture 16.

The final assembly is shown in Figure 4 including retention means 20 for securing the child board 4 in position.

The boards 12, 14 are fabricated from a moulded material which is flexible during connection yet lending enough support for the surface mounted components in the final assembly.

The angle $\theta$ of the chamferred edges is chosen so as to ensure easy assembly of the child board 14 and the daughter board 12.

Furthermore, the angle $\theta$ is chosen, to enable horizontal component forces to establish a direct electrical connection between the contacts 18 on the child board 4 and the contacts 18 on the daughter board 2, thus providing a gas tight connection. Such a gas tight connection substantially stops deposits forming on the contacts 18 and also reduces any capacitance between the contacts 18.

This method of connection improves reliability and the MTBF since there is no separable connection. Also the absence of such a connector increases air flow across the boards 12, 14 hence increasing heat dissipation.

The foregoing description has been given by way of example only and modifications may be made without departing from the scope of the present invention. Such modifications may include:

1. The angle $\theta$ of the edges of the child board 14, may not be equal to the angle of the walls of the aperture 16.

2. The edges of the aperture 16 and the walls of the child board 14, may be moulded such that their cross-section forms a parallelogram. The method of connection may then be modified such that a plane of perpendicular forces transverses the boards 12, 14.

3. The angle of the edges of the child board 14 and the child board 14 and the walls of the aperture 16 may be any combination of normal or acute angles.

4. The child board 14 may not include hooks 20, but secured to the daughter board 12 by alternative means.

## Claims

1. A Hierarchical Interconnection Technology (HIT) system comprising a module and a board having at least one aperture for receiving the module and means being provided for resiliently maintaining the module in the aperture.

2. A HIT system as claimed in claim 1 wherein the means for resiliently maintaining the module in the aperture includes part of the board and/or part of the module being fabricated from a moulded material.

3. A HIT system as claimed in claim 1 or claim 2, wherein the module comprises two planes having at least one edge therebetween whereby the means for resiliently maintaining the module in the aperture includes having at least one edge being chamfered.

4. A HIT system as claimed in any one of claims 1 to 3, wherein the or each aperture comprises at least one wall whereby at least one walls is chamfered.

5. A HIT system as claimed in any one of the preceding claims, wherein the shape of the aperture and the shape of the module are substantially complimentary.

6. A method of connection of a Hierarchical Interconnection Technology (HIT) system comprising a module and a board having at least one aperture for receiving the module, the method comprising superimposing the module on the aperture, applying a force to the module substantially normal to the plane of the board, and removing the force when the module is being resiliently maintained in the aperture.

7. A method of connection for HIT system substantially as hereinbefore described.

8. A HIT system substantially as hereinbefore described with reference to any one of Figures 3 or 4.

FIG. I.

FIG. 2.

FIG. 3.

FIG. 4.